# EUROPÄISCHE PATENTANMELDUNG

(11) **EP 2 418 695 A2**
(43) Veröffentlichungstag der Anmeldung: **15.02.2012**
(21) Anmeldenummer: 11176619.2
(22) Anmeldetag: 04.08.2011
(51) Int. Cl.: H01L 31/052, H01L 31/058

(54) **Anordnung zur Kühlung von Solarzellen**

(30) Priorität: 12.08.2010 DE 102010039279
(71) Anmelder: Ripal GmbH, 01471 Radeburg (DE)
(72) Erfinder: Jürgen, Trog, 01471 Radeburg (DE)
(74) Vertreter: Kailuweit & Uhlemann Patentanwälte

(57) **Zusammenfassung**

Es wird eine Wärmetauscherkonstruktion zur Kühlung von Solarzellenmodulen offenbart, wobei der Wärmetauscher mehrere, von einem Wärmeträgermedium durchströmte Plattenelemente aufweist, die durch flexible Verbindungen miteinander verbunden sowie gegeneinander faltbar sind und wobei wenigstens eine der flexiblen Verbindungen vom Wärmeträgermedium durchströmt werden kann. Die Plattenelemente werden flächig auf der sonnenabgewandten Seite der Solarzellenmodule angeordnet. Weiterhin werden Verfahren zur Installation der erfindungsgemäßen Wärmetauscher unter den Solarzellenmodulen beschrieben.

## Beschreibung

Gegenstand der vorliegenden Erfindung ist ein Wärmetauscher, der mehrere, durch flexible Verbindungselemente verbundene Plattenelemente aufweist. Dieser Wärmetauscher lässt sich in einem ebenfalls offenbarten Verfahren, insbesondere unter bestehenden Solarzellenmodulen, zwischen diesen Modulen und der Oberfläche, auf der diese montiert sind, anordnen.

Der Wirkungsgrad von Solarzellen, insbesondere Siliziumsolarzellen, ist von der Temperatur abhängig, bei der der Betrieb der Solarzelle erfolgt. Je höher die Temperatur der Solarzellen ist, desto geringer ist die fotovoltaische Ausbeute. Aus diesem Grunde werden seit Kenntnis dieses Zusammenhanges Versuche unternommen, Solarzellen bei möglichst tiefen Temperaturen zu halten und zu betreiben. Die Verwendung so genannter Kombizellen, die sowohl thermische als auch fotovoltaische Energiegewinnung ermöglicht, ist bekannt.

So wird in der DE 10 2006 003 802 A1 die Kombination einer Solarzelle mit einem Wärmetauscherelement vorgestellt. Neben elektrischer Energie soll, zur Verbesserung des Gesamtwirkungsgrades, auch thermische Energie gewonnen werden. Das Wärmetauscherelement ist plattenförmig und an der Rückseite der Solarzelle angeordnet. Die gewonnene Wärme soll für die Warmwasserbereitung genutzt werden. Solarzellen und Wärmetauscher bilden eine Einheit. Eine Nachrüstung bestehender Solarzellenanordnungen ist nicht vorgesehen.

Üblicherweise sind mehrere Solarzellen zu so genannten Solarzellenmodulen oder Solarpaneelen zusammengefasst.

Es ist jedoch nicht zu verkennen, dass Wärmegewinnung und fotovoltaische Nutzung konkurrierende Prozesse sind, da die Wärmegewinnung umso effektiver ist, je höher die erzielte Temperatur ist, während bei höheren Temperaturen gerade die Effektivität der fotovoltaischen Nutzung abnimmt.

In der WO 2009/60034 A1 werden auf der Rückseite von Solarzellenmodulen Temperierelemente angeordnet, die aus in Graphitexpandat eingebetteten Wärmeträgerrohren bestehen. In den Wärmeträgerrohren zirkuliert eine Temperierflüssigkeit, die die Solarzellen kühlen soll. Die Möglichkeit der Nutzung der Wärme wird lediglich erwähnt und nicht näher ausgeführt.

Vom Standpunkt der Arbeitsfähigkeit her ist elektrische Energie natürlich der thermischen Energie vorzuziehen. Bei den oben genannten konkurrierenden Prozessen ist deshalb die Erzeugung elektrischer Energie vorzuziehen.

In vielen praktischen Fällen wird daher bereits bei der Montage auf die Möglichkeit einer Reduzierung der Betriebstemperatur der Solarzellen verzichtet und die Solarzellen werden ohne Kühlung betrieben. Problematisch ist auch die nachträgliche Ausrüstung einer bestehenden Solarzelleninstallation mit einer Kühlung.

Die Nachrüstung bestehender Solarzelleninstallationen erfordert meist, dass die bestehenden Zellen vom Dach entfernt und gegen neue Kombizellen ausgetauscht werden. Sollen die vorhandenen Zellen beibehalten werden, so ist eine nachträgliche Montage einer Wärmetauscheranordnung hinter diesen Zellen schwierig, da die Wärmetauscher naturgemäß in ihren Abmessungen weitgehend denen der aktiven Flächen der Solarzellenmodule entsprechen müssen und demzufolge schwierig zu handhaben sind. Auch die gemeinsame Installation von Solarzellenmodulen, für die keine Kühlung vorgesehen war, mit einer Kühlvorrichtung, ist wirtschaftlich interessant.

Aufgabe der vorliegenden Erfindung ist es, eine Wärmetauscherkonstruktion vorzuschlagen, die die Nachrüstung bestehender Solarzellenanordnungen erleichtert, indem sie ohne oder mit einer teilweisen Demontage der bestehenden Solarzellenmodule auskommt und aufgrund ihrer erfindungsgemäßen Vorteile besonders gut handhabbar ist. Die Wärmetauscherkonstruktion soll auch eine leichte Installation gemeinsam mit Solarzellenmodulen, für die keine Kühlung vorgesehen war, ermöglichen.

Erfindungsgemäß wird diese Aufgabe mit der Vorrichtung nach Anspruch 1 gelöst. Vorteilhafte Ausgestaltungen sind in den rückbezogenen Unteransprüchen dargestellt. Ein Verfahren zur Montage des erfindungsgemäßen Wärmetauschers wird in Anspruch 10 offenbart und in den rückbezogenen Unteransprüchen untersetzt.

Die erfindungsgemäße Vorrichtung ist ein Wärmetauscher, bevorzugt zur Montage hinter bestehende Solarzellenanordnungen oder gemeinsam mit Solarzellenmodulen, für die keine Kühlung vorgesehen war, der aus zwei oder mehreren Plattenelementen besteht, die flexibel miteinander verbunden sind. Der erfindungsgemäße Wärmetauscher ist insbesondere für Solarzelleninstallationen geeignet, bei denen zwischen der Oberfläche auf der die Solarzellenmodule installiert sind und den Solarzellenmodulen selbst, ein hinreichend großer Abstand besteht. Dieser Abstand sollte vorteilhaft 3 cm bis 15 cm, bevorzugt 5 cm bis 10 cm betragen.

Der Wärmetauscher kann in einer bevorzugten Ausführungsform so an den flexiblen Verbindungen der Plattenelemente gefaltet werden, dass die Plattenelemente aufeinander zu liegen kommen. Dies ermöglicht einen besonders leichten Transport an den Einbauort und eine erleichterte Handhabung beim Einbau.

Der Wärmetauscher wird hinter den bestehenden Solarpaneelen, auf deren sonnenabgewandter Seite, angeordnet. Die Solarzellenmodule sind üblicherweise auf mindestens vier, häufig sechs oder acht Trägerelementen befestigt, wobei die Trägerelemente die Solarzellenmodule an deren Ecken und Kanten halten. Zur Montage des erfindungsgemäßen Wärmetauschers werden bevorzugt die Tragelemente der Solarzellen genutzt, auf denen dann der erfindungsgemäße Wärmetauscher mit befestigt wird. In einer weiteren bevorzugten Ausführungsform werden gesonderte Tragelemente für den Wärmetauscher, bevorzugt in Form von stabförmigen Profilen, auf der Oberfläche befestigt.

Diese Tragprofile auf denen der Wärmetauscher befestigt wird, weisen vorteilhaft Justiermöglichkeiten auf. Die Justiermöglichkeiten können als Schraubvorrichtungen, Klemmvorrichtungen oder ähnliches ausgeführt sein. In einer bevorzugten Ausführungsform sind die Justiermöglichkeiten elastisch, so dass sie auch nach einem Arretieren einen stetigen Anpressdruck ausüben. Bei der Montage wird der erfindungsgemäße Wärmetauscher unter den bestehenden Solarzellenmodulen angeordnet. Da der Wärmetauscher aus mindestens zwei gegeneinander faltbaren Plattenelementen besteht, ist diese Montage besonders leicht ausführbar.

Durch die flexible Verbindung der Plattenelemente können diese unabhängig voneinander justiert werden. Die Justiermöglichkeiten werden nach dem Einbau der Plattenelemente genutzt, um einen direkten vollflächigen Kontakt der Plattenelemente mit der Rückseite der Solarzellenmodule herzustellen und beizubehalten. In einer bevorzugten Ausführungsform wird die Wärmeleitung durch eine Wärmeleitfolie oder eine Schicht Wärmeleitpaste zwischen der Rückseite des Solarpanels und dem Plattenelement verbessert. Bei Solarzellenmodul-Bauformen, die eine geschlossene Rückseite aufweisen, ist die Rückseitenabdeckung vorteilhaft vor dem Einbau des Wärmetauschers zu entfernen.

Es ist ebenso möglich, die erfindungsgemäßen Wärmetauscher bei der Errichtung neuer Fotovoltaikanlagen mit einzubauen. Hier können preisgünstigere Solarzellenmodule zum Einsatz kommen, für die eigentlich keine Rückseitenkühlung vorgesehen war.

Die flexible Verbindung der Plattenelemente erfolgt mittels flexibler Verbinder bzw. Verbindungselemente, von denen wenigstens eines von dem Wärmeträgermedium durchströmt wird. Bevorzugt werden hier flexible Schläuche aus Kunststoffen, Teflon, Metallgeflecht oder Verbundmaterialien eingesetzt. Es ist auch der Einsatz von metallbalgartigen Verbindern möglich. In einer weiteren bevorzugten Ausführungsform sind die Verbinder aus starrem Material, und mit einem oder mehreren durchströmbaren Gelenken verbunden. Die Plattenelemente sind bevorzugt so geschaltet, dass sie nacheinander vom Wärmeträgermedium durchströmt werden. Vom ersten und vom letzten durchströmten Plattenelement führen die Verbinder zu Sammelleitungen, die an die Vorlauf- und Rücklaufleitungen des Wärmeträgermediums angeschlossen werden. Diese Verbinder können ebenfalls flexibel, aber auch starr ausgebildet sein. Die Plattenelemente sind in einer bevorzugten Ausführungsform als zwei beabstandete, an den Rändern verbundene Flächenelemente ausgebildet. Zwischen den Flächenelementen verlaufen die Kanäle, die von dem Wärmeträgermedium durchströmt werden. Die Kanäle stehen an zwei gegenüberliegenden Kanten der Flächenelemente mit flexiblen Verbindungselementen in Verbindung, die ebenfalls von dem Wärmeträgermedium durchströmt werden. Die Kanäle verlaufen dabei bevorzugt parallel, schleifenförmig, mäandernd oder in Zick-Zack-Form, um zu gewährleisten, dass möglichst die gesamte Kontaktfläche des Plattenelements mit der Rückseite des Solarzellenmoduls vom Wärmeträgermedium gekühlt wird. Die Plattenelemente sind bevorzugt aus statisch versteiftem, profiliertem Aluminium gefertigt. Auch eine Fertigung aus anderen Leichtmetallen, Kupfer oder Kunststoffen, mit erhöhter Wärmeleitfähigkeit (beispielsweise durch den Zusatz von Metallpartikeln, Graphit, oder ähnlichen Lösungen aus dem Stand der Technik) ist möglich. Die von der Rückseite des Solarzellenmoduls abgewandte Seite des Plattenelements kann vorteilhaft mit einer Wärmedämmung versehen sein.

Eine weitere bevorzugte Bauform der Plattenelemente weist ein Kühlblech auf, auf dessen Rückseite zur Versteilung ein profiliertes Blech oder Versteifungsrippen oder -träger angeordnet sind. Das Plattenelement liegt mit dem Kühlblech im montierten Zustand weitestgehend vollflächig auf der Rückseite des Solarpanels auf. An der dem Solarzellenmodul abgewandten Seite des Kühlblechs, bzw, falls vorhanden des profilierten Blechs, sind Rohrleitungen angeordnet, die in wärmeleitenden Kontakt mit dem Kühlblech stehen. Die Rohleitungen sind dabei in Mustern geführt, so dass möglichst über die gesamte Fläche der Kühlbleche Wärme auf das Wärmeträgermedium übertragen wird, Diese Muster sind dabei bevorzugt parallel, schleifenförmig, mäandernd oder in Zick-Zack-Form ausgeführt.

In einer bevorzugten Ausführungsform weisen die Plattenelemente Kühlbleche auf, die selbst profiliert sind oder an deren, von der Solarzelle abgewandten Seite, ein profiliertes Blech angeordnet ist. Diese Plattenelemente weisen an Ihrer Unterseite parallel geführte Schläuche auf, die vom Vorlauf- bis zum Rücklaufsammelrohr ununterbrochen geführt sind und im Bereich der Plattenelemente direkten wärmleitenden Kontakt zum Kühlblech bzw. zu dem an dessen Unterseite angeordneten profilierten Blech haben. Diese Schläuche sind bevorzugt aus PVC oder einem anderen Plastikmaterial. Besonders bevorzugt bestehen die Schläuche aus PE (Polyethylen). An den Verbindungsstellen zwischen den Plattenelementen sind die Schläuche gegen Witterungseinflüsse geschützt und weisen bevorzugt einen UV-Schutz auf. Die Schläuche werden auf der Rückseite durch Kleben oder andere material-, kraft-, oder formschlüssige Mittel aus dem Stand der Technik gehalten. Aufgrund dieser Bauweise, mit parallelen, durchgehend geführten Schläuchen, ist die Herstellung des erfindungsgemäßen Wärmetauschers besonders kostengünstig möglich.

In einer weiteren bevorzugten Ausführungsform sind die Rohrleitungen an den Seiten, wo sie keinen Kontakt zu dem Kühlblech bzw. zu Anschlüssen und Stützelementen haben, von einem Wärmedämmmaterial umhüllt. Dazu werden bspw. Polyurethan, Steinwolle oder andere Lösungen aus dem Stand der Technik genutzt.

In einer bevorzugten Ausführungsform sind die Justierelemente an den Plattenelementen des Wärmetauschers angeordnet. Die Justierelemente sind bevorzugt dauerhaft elastisch.

In einer bevorzugten Ausführungsform wird ein Wärmetauscher unter mehreren Solarzellenmodulen angeordnet, indem unter nebeneinanderliegende Module ein gemeinsamer Wärmetauscher angeordnet wird. Der erfindungsgemäße Wärmetauscher wird bevorzugt in einer weitgehend vertikalen Position eingebaut, da dies die Entlüftung bei der Befüllung mit Wärmetauschermedium erleichtert. Es ist jedoch auch ein weitgehend vertikaler Einbau möglich, bei dem die Plattenelemente nebeneinander zu liegen kommen.

Als Wärmeträgermedium kommt bevorzugt Wasser, vorteilhaft unter Zusatz von Frostschutzmitteln, zum Einsatz.

Durch die flexible Verbindung der Plattenelemente eines Wärmetauschers kann dieser zum Transport zusammengeklappt (gefaltet) werden. Dies ermöglicht eine leichtere Handhabung des Wärmetauschers. Auch ist bei der Montage des Wärmetauschers unter bestehende Solarpaneele weniger Platz notwendig, um den Wärmetauscher unter den Solarzellenmodulen positionieren zu können. Die einzelnen Plattenelemente liegen im gefalteten Zustand des Wärmetauschers flächig direkt aufeinander oder sind lediglich durch einen Oberflächenschutz voneinander getrennt. Zum Schutz der Oberflächen der Plattenelemente sind entsprechende Schutzfolien, Zwischenlagen aus Plastik, Pappe, Papier oder Holz oder anderen Stoffen mit geringerer Härte als sie die Oberfläche der Plattenelemente aufweist, geeignet.

Das erwärmte Wärmeträgermedium strömt vom Wärmetauscher bevorzugt zu einer Verwertungsvorrichtung für die Wärme. Dazu kommen vorteilhaft Wärmepumpenanlagen oder Erdwärmespeicher zum Einsatz. Der erfindungsgemäße Wärmetauscher hält die Temperatur der Solarzellenrückseite bevorzugt geringer als 60 °C, besonders bevorzugt geringer als 50 °C und weiterhin besonders bevorzugt in der Größenordnung von etwa 25 °C. Die über längere Zeiträume verfügbare Rücklauftemperatur vom Wärmetauscher liegt somit deutlich im Niedertemperaturbereich. Daher ist ein kostengünstiger Einsatz dieser Wärme bevorzugt für die Wärmebeladung von Erdwärmespeichern sinnvoll.

Das bestehende Solarzellenmodul muss in einer bevorzugten Verfahrensweise von seinen Tragelementen gelöst und seitlich, bevorzugt auf einem anderen, noch befestigten Solarzellenmodulen vorübergehend gelagert und fixiert werden. Ein Entfernen vom Dach ist nicht notwendig, falls geeignete weitere Solarzellenmodule oder andere Lagermöglichkeiten auf dem Dach zur Verfügung stehen. Anschließend werden auf den Tragelementen des Solarzellenmoduls Justierelemente angeordnet, auf die dann die Plattenelemente des Wärmetauschers aufgelegt werden. Die Justierelemente werden so eingestellt, dass nach dem Wiedereinbau des Solarzellenmoduls die Plattenelemente in flächigem Kontakt mit der Rückseite des Solarzellenmoduls stehen und dieser durch die Justierelemente aufrecht erhalten wird. Anschließend werden die Solarzellenmodule wieder zurück in ihre Ausgangsposition gebracht und befestigt. Abschließend werden die Vorlauf- und Rücklaufsammelrohre an den Wärmeträgerkreislauf angeschlossen.

Eine weitere bevorzugte Verfahrensweise wird angewendet, wenn der Abstand der bestehenden Solarzellen zu der Dachoberfläche ausreichend groß ist und die Solarzellenmodule an ihren Rändern keine nach unten gezogenen Rahmen aufweisen. Dann ist es möglich, den erfindungsgemäßen Wärmetauscher unter die bestehenden Solarzellen zu schieben, wobei diese nicht oder nur teilweise (bspw. einseitig) demontiert werden müssen. Die Justierelemente und die Plattenelemente werden auf den Tragelementen der vorhandenen Solarzellen angebracht.

Ein weiteres bevorzugtes Verfahren zur Montage der erfindungsgemäßen Wärmetauscher sieht vor, dass unter den Solarzellenmodulen stabförmige Tragvorrichtungen mit den Justierelementen installiert werden. Daraufhin wird der zusammengefaltete Wärmetauscher an den Einbauort transportiert. Da die Flächenmasse des Wärmetauschers in einfachen Bauformen bei etwa 3kg/m² liegt, ist dies vorteilhaft ohne Hebezeug möglich. Lediglich bei schwereren Bauformen ist ein Hebezeug vorzusehen. Es wird das erste Plattenelement ausgeklappt und auf die Tragvorrichtungen unter das Solarzellenmodul geschoben. Anschließend wird das folgende Plattenelement ausgeklappt und der Wärmetauscher weiter unter das Solarzellenmodul geschoben. Das erste Plattenelement wird dabei weiter unter das Solarzellenmodul geschoben. Dies wird so lang fortgesetzt, bis der Wärmetauscher in der beabsichtigten Position unter dem Solarzellenmodul angeordnet ist. Nunmehr werden über die Justierelemente die Plattenelemente soweit an die Rückseite des Solarzellenmoduls herangeführt, bis ein flächiger Kontakt mit dieser hergestellt ist. Die Justierelemente werden nun in dieser Lage arretiert, um den Zustand des flächigen Kontakts aufrecht zu erhalten. Abschließend werden die Vorlauf-und Rücklaufsammelrohre an einen Wärmeträgerkreislauf angeschlossen, der das Wärmeträgermedium zu einer Nutzung der Wärme, bzw. von dieser Nutzung zurück, zum Vorlaufsammelrohr, führt.

Bei der Montage des erfindungsgemäßen Wärmetauschers beim Neueinbau einer Solaranlage wird nach dem Aufbringen der Tragelemente für die Solarzellenmodule auf diesen Tragelementen der Wärmetauscher vollkommen entfaltet aufgelegt. Die Justierelemente zwischen Wärmetauscher und Tragelement sind elastisch und justierbar. Durch die anschließende Montage des Solarzellenmoduls wird eine Kraft auf den Wärmetauscher ausgeübt. Die Justierelemente bringen die erforderliche Gegenkraft auf, so dass die Plattenelemente zuverlässig und dauerhaft flächig gegen die Rückseiten der Solarzellenmodule gepresst werden.

In einer bevorzugten Ausführungsform wird, bereits bevor der Wärmetauscher an den Einbauort transportiert wird, eine Wärmeleitfolie oder Wärmeleitpaste auf die Plattenelemente aufgebracht. Alternativ kann dies auch erst am Einbauort, auf dem jeweils entfalteten Plattenelement, oder vor dem Justieren auf allen, dann bereits entfalteten Plattenelementen, unter dem Solarzellenmodul erfolgen.

### Figuren

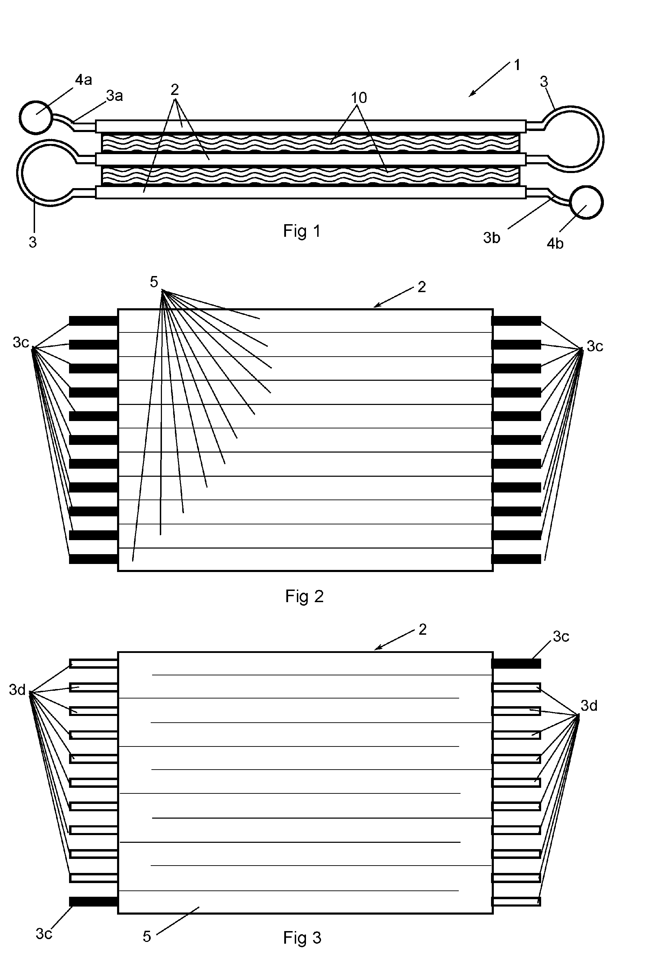

**Fig. 1** zeigt die schematisierte Seitenansicht des erfindungsgemäßen Wärmetauschers (1). Dieser besteht in der dargestellten Ausführungsform aus drei Plattenelementen (2), die mit flexiblen Verbindungselementen (3) verbunden sind. Die Plattenelemente (2) liegen flächig aufeinander und sind lediglich durch einen Oberflächenschutz (10) voneinander getrennt. Am ersten Plattenelement (2) ist über das flexible Verbindungselement (3a) die Vorlaufsammelleitung (4a) angeschlossen. Das flexible Verbindungselement (3b) verbindet die Rücklaufsammelleitung (4b) mit dem letzten Plattenelement (2). In der dargestellten zusammengefalteten Form ist der Wärmetauscher (1) besonders leicht an seinen Einbauort zu transportieren. Die kompakte zusammengefaltete Form gestattet eine problemlose Handhabung des Wärmetauschers mittels einfacher Hebezeuge.
**Fig. 2** zeigt eine schematisierte Darstellung des inneren Aufbaus eines Plattenelementes (2). Das Plattenelement (2) ist von parallel verlaufenden Kanälen (5) durchzogen, in denen das Wärmeträgermedium strömt. Die flexiblen Verbindungselemente (3c) werden alle vom Wärmeträgermedium durchströmt. Sie stellen die Verbindung zu den benachbarten Plattenelementen (2) des Wärmetauschers (1) bzw. zu den Sammelleitungen für Vor- und Rücklauf her.
**Fig. 3** zeigt eine weitere schematisierte Darstellung des inneren Aufbaus eines Plattenelementes (2). Das Plattenelement (2) ist von einem mäandernden Kanal (5) durchzogen, in dem das Wärmeträgermedium strömt. Die flexiblen Verbindungselemente (3c) werden vom Wärmeträgermedium durchströmt. Die flexiblen Verbindungselemente (3d) werden hingegen nicht vom Wärmeträgermedium durchströmt und dienen der Stabilität der Verbindung der Plattenelemente (2).

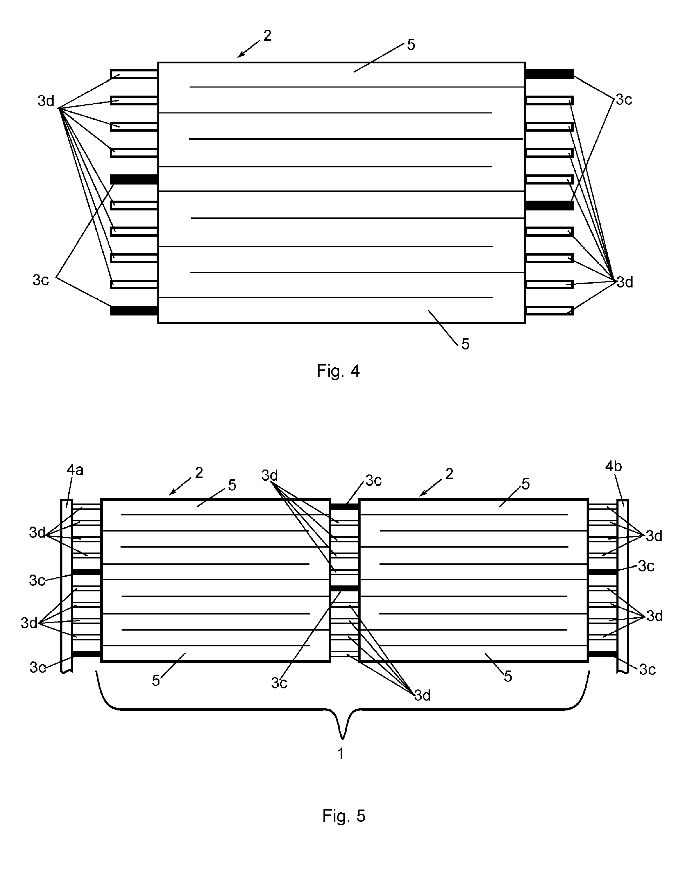

**Fig. 4** zeigt eine schematisierte Darstellung eines Plattenelements (2) mit zwei mäandernden Kanälen (5).
**Fig. 5** zeigt einen Wärmetauscher (1), der aus zwei Plattenelementen (2) besteht. Jedes der Plattenelemente (2) weist zwei mäandernde Kanäle (5) auf, die vom Wärmeträgermedium durchströmt werden. Die Plattenelemente sind durch flexible Verbindungselemente (3d), durch die kein Wärmeträgermedium strömt, sowie durch flexible Verbindungselemente (3c), die vom Wärmeträgermedium durchströmt werden, verbunden. Das Wärmeträgermedium strömt dabei durch die Vorlaufsammelleitung (4a) und durch flexible Verbindungselemente te (3c), die von Wärmeträgermedium durchströmt werden, in das links dargestellte Plattenelement (2). Von hier aus gelangt es durch weitere flexible Verbindungselemente (3c), die von Wärmeträgermedium durchströmt werden, in das rechts dargestellte Plattenelement (2) um dann über weitere flexible Verbindungselemente (3c), die von Wärmeträgermedium durchströmt werden, in die Rücklaufsammelleitung zu gelangen.

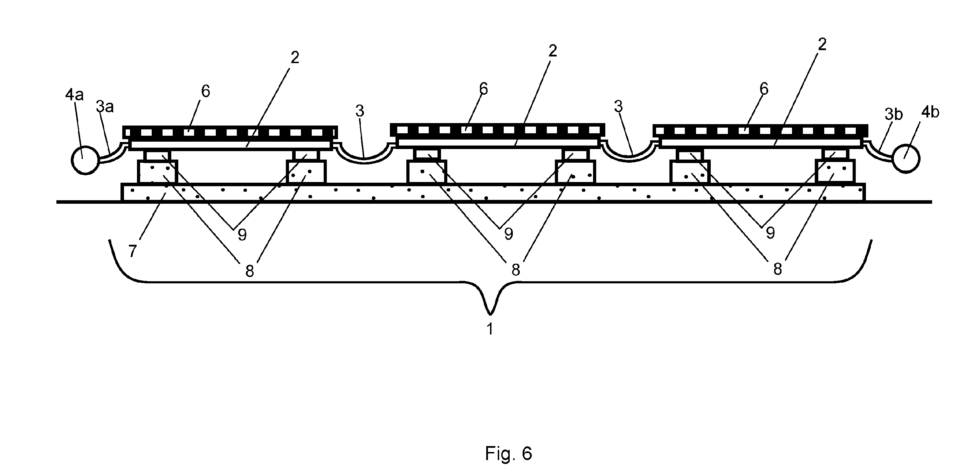

**Fig. 6** zeigt eine schematisierte Seitenansicht des installierten Wärmetauschers (1). Die Plattenelemente (2) sind unter Gruppen von Solarzellen (6) von Solarzellenmodulen angeordnet. Die Trägereinrichtungen der Solarzellenmodule sind nicht dargestellt. Der Wärmetauscher wird von vertikalen Tragelementen (7), auf denen sich horizontale Tragelemente (8) befinden, getragen. Der flächige Kontakt der Plattenelemente (2) zur Rückseite der Solarzellenmodule (8) wird durch die Justiermöglichkeiten (9) eingestellt und aufrechterhalten.

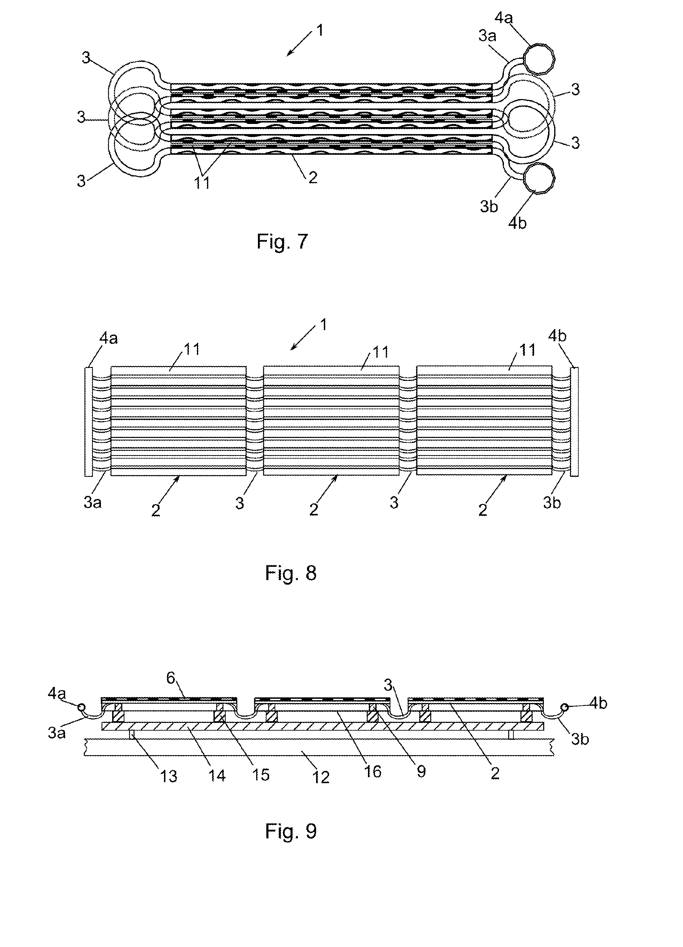

**Fig. 7** zeigt einen erfindungsgemäßen Wärmetauscher (1), der sechs Plattenelemente (2) aufweist in gefaltetem Zustand. In der gezeigten Bauform werden die Plattenelemente (2) durch Kühlbleche (11) gebildet, an deren Unterseite eine Mehrzahl parallel verlaufender flexibler Schläuche angeordnet ist, die auch die flexiblen Verbindungen (3, 3a, 3b) zwischen den Plattenelementen (2) und zu den Sammelleitungen (4a, 4b) bilden. Die Dicke eines Plattenelementes beträgt ca. 1 cm, wobei ca. 0,8cm auf die flexiblen Schläuche und die verbleibenden ca. 0,2 cm auf das profilierte Kühlblech entfallen.
**Fig. 8** zeigt eine schematische Darstellung eines erfindungsgemäßen Wärmetauschers, der eine Mehrzahl parallel verlaufender flexibler Schläuche aufweist, die durchgehend von der Vorlaufsammelleitung (4a) bis zur Rücklaufsammelleitung (4b) geführt sind. Im Bereich der Plattenelemente (2) sind die Schläuche in direktem wärmeleitendem Kontakt mit den Kühlblechen (11). Zwischen den Plattenelementen (2) bilden die parallel verlaufenden flexiblen Schläuche die flexiblen Verbindungen (3) der Plattenelemente. Zwischen Vorlaufsammelleitung (4a) und erstem Plattenelement (2) bilden die parallel verlaufender flexiblen Schläuche das flexible Verbindungselement (3a) sowie zwischen Rücklaufsammelleitung (4b) und dem letztem Plattenelement (2) bilden die parallel verlaufender flexiblen Schläuche das flexible Verbindungselement (3b).
**Fig. 9** zeigt den erfindungsgemäßen Wärmetauscher im Einbauzustand. Die Plattenelemente (2) sind unter den Solarzellenmodulen (6) angeordnet. Die Plattenelemente sind dabei auf Justierelementen (9) angeordnet, die ihrerseits auf den Trageelementen (13, 14, 15) des Solarzellenmoduls (6) angebracht sind. Die vorliegende Solarmodulkonstruktion weist einen heruntergezogenen Rahmen (16) auf. Die Plattenelemente werden seitlich von diesem Rahmen verdeckt. Aufgrund des flexiblen Charakters der Verbindungselemente (3, 3a, 3b) können diese um die Rahmenkante (16) des Solarmoduls herumgeführt sein. Somit sind keine konstruktiven Veränderungen an den Solarzellenmodulen notwendig.

### Bezugszeichenliste

- 1: Wärmetauscher
- 2: Plattenelement
- 3: flexibles Verbindungselement
- 3a: flexibles Verbindungselement zur Vorlaufsammelleitung
- 3b: flexibles Verbindungselement zur Rücklaufsammelleitung
- 3c: vom Wärmeträgermedium durchströmtes flexibles Verbindungselement
- 3d: nicht vom Wärmeträgermedium durchströmtes flexibles Verbindungselement
- 4a: Vorlaufsammelleitung
- 4b: Rücklaufsammelleitung
- 5: Kanal für das Wärmeträgermedium im Plattenelement
- 6: Gruppen von Solarzellen
- 7: vertikales Trägerelement für den Wärmetauscher
- 8: horizontales Trägerelement für den Wärmetauscher
- 9: Justiermöglichkeit
- 10: Oberflächenschutz der Plattenelemente im zusammengefalteten Zustand
- 11: Kühlblech
- 12: Montageoberfläche (bspw. Dachfläche, Fassade)
- 13: Untergrundbefestigungselemente (bspw. Haken, Konsolen)
- 14: Senkrechte Befestigungsschienen
- 15: Waagerechte Befestigungsschienen
- 16: Rahmenkante des Solarzellenmoduls

## Patentansprüche

1. Wärmetauscher (1) zur Kühlung von Solarzellenmodulen (6) mit einem Wärmeträgermedium, wobei der Wärmetauscher (1) mehrere, vom Wärmeträgermedium durchströmte Plattenelemente (2) aufweist, die durch flexible Verbindungen (3) miteinander verbunden sowie gegeneinander faltbar sind und wobei wenigstens eine der flexiblen Verbindungen (3) vom Wärmeträgermedium durchströmt wird und die Plattenelemente (2) flächig auf der sonnenabgewandten Seite der Solarzellenmodule (6) aufliegen.

2. Wärmetauscher (1) nach Anspruch 1, **dadurch gekennzeichnet, dass** die flexiblen Verbindungen (3) aus Schläuchen aus Kunststoffen, Teflon, Metallgeflecht oder Verbundmaterialien bestehen oder als metallbalgartige Verbinder oder als starre Verbindungsteile mit mindestens einem Gelenk ausgebildet sind.

3. Wärmetauscher (1) nach Anspruch 1 oder 2, **dadurch gekennzeichnet, dass** die Plattenelemente (2) als Kühlbleche mit einseitig aufgebrachten Wärmeträgerrohren (5) ausgeführt sind, wobei die Kühlbleche flächig auf der Rückseite der Solarzellenmodule (6) aufliegen.

4. Wärmetauscher (1) nach Anspruch 3, **dadurch gekennzeichnet, dass** die Wärmeträgerrohre (5) parallel zueinander, schleifenförmig, mäandernd oder in Zick-Zack-Form auf dem Kühlblech angeordnet sind.

5. Wärmetauscher (1) nach Anspruch 4, **dadurch gekennzeichnet, dass** die Wärmeträgerrohre (5) an den Seiten, wo sie keinen Kontakt zu dem Kühlblech, zu Anschlüssen und/oder Stützelementen haben, von einem Wärmedämmmaterial umhüllt sind.

6. Wärmetauscher (1) nach einem der vorhergehenden Ansprüche, **dadurch gekennzeichnet, dass** zwischen der Rückseite der Solarzellenmodule (6) und den Plattenelementen (2) Wärmeleitfolie oder eine Schicht Wärmleitpaste angeordnet ist.

7. Wärmetauscher (1) nach einem der vorhergehenden Ansprüche, **dadurch gekennzeichnet, dass** die Plattenelemente (2) in Reihe geschaltet sind und über, mit Gelenk versehene, starre oder über flexible Verbindungen (3a, 3b) das erste Plattenelement (2) mit einem Vorlaufsammelrohr (4a) und das letzte Plattenelement (2) mit einem Rücklaufsammelrohr (4b) verbunden sind.

8. Wärmetauscher (1) nach einem der vorhergehenden Ansprüche, **dadurch gekennzeichnet, dass** der Wärmetauscher (1) so an den flexiblen Verbindungen (3) der Plattenelemente gefaltet werden kann, dass die Plattenelemente (2) flächig aufeinander liegen.

9. Wärmetauscher (1) nach einem der vorhergehenden Ansprüche, **dadurch gekennzeichnet, dass** der Wärmetauscher (1) mit einer Wärmepumpenanlage und/oder einem Erdwärmespeicher verbunden ist.

10. Verfahren zur Montage eines Wärmetauschers (1) nach einem der vorhergehenden Ansprüche, wobei mindestens die folgenden Schritte ausgeführt werden:
a. Installation von stabförmigen Tragvorrichtungen (7, 8) mit Justierelementen (9) unter den Solarzellenmodulen (6);
b. Transport des zusammengefalteten Wärmetauschers (1) an den Einbauort
c. Ausklappen des ersten Plattenelements (2) und Verschieben des Plattenelements (2) auf die Tragvorrichtung (7, 8) und unter das Solarzellenmodul (6);
d. Ausklappen des folgenden Plattenelements (2) und Schieben des Plattenelements (2) auf die Tragvorrichtungen (7, 8) und unter das Solarzellenmodul (6);
e. Wiederholen von Schritt d) bis der Wärmetauscher (1) unter dem Solarzellenmodul (6) angeordnet ist;
f. Heranführen der Plattenelemente (2) an die Rückseite des Solarzellenmoduls (6), bis zum flächigen Kontakt mittels der Justierelemente (9);
g. Arretieren der Justierelemente (9);
h. Anschluss der Vorlauf- (4a) und Rücklaufsammelrohre (4b) an einen Wärmeträgerkreislauf.

11. Verfahren zur Montage eines Wärmetauschers (1) nach einem der vorhergehenden Ansprüche, wobei mindestens die folgenden Schritte ausgeführt werden:
a. Installation von stabförmigen Tragvorrichtungen (7, 8) mit Justierelementen (9) unter den Solarzellenmodulen (6);
b. Transport des zusammengefalteten Wärmetauschers (1) an den Einbauort
c. Ausklappen des ersten Plattenelements (2) und Verschieben des Plattenelements (2) auf die Tragvorrichtung (7, 8) und unter das Solarzellenmodul (6);
d. Ausklappen des folgenden Plattenelements (2) und Schieben des Plattenelements (2) auf die Tragvorrichtungen (7, 8) und unter das Solarzellenmodul (6);
e. Wiederholen von Schritt d) bis der Wärmetauscher (1) unter dem Solarzellenmodul (6) angeordnet ist;
f. Heranführen der Plattenelemente (2) an die Rückseite des Solarzellenmoduls (6), bis zum flächigen Kontakt mittels der Justierelemente (9);
g. Anschluss der Vorlauf- (4a) und Rücklaufsammelrohre (4b) an einen Wärmeträgerkreislauf.

12. Verfahren nach Anspruch 10 oder 11, **dadurch gekennzeichnet, dass** auf allen Plattenelementen (2) vor Schritt b., oder am Einbauort auf dem jeweils entfalteten Plattenelement (2) nach Schritt c. oder d., oder vor Schritt f., Wärmeleitfolie oder Wärmeleitpaste auf der dem Solarzellenmodul (6) zugewandten Seite der Plattenelemente (2) aufgebracht wird.

13. Verfahren zur Montage eines Wärmetauschers (1) nach einem der Ansprüche 1 bis 9, wobei mindestens die folgenden Schritte ausgeführt werden:
a. Demontage eines Solarzellenmoduls (6) und Lagerung sowie Fixierung des Solarzellenmoduls (6) auf einem benachbarten Solarzellenmodul (6)
b. Installation von Justierelementen (9) auf den Tragelementen des Solarzellenmoduls (6);
c. Transport des zusammengefalteten Wärmetauschers (1) an den Einbauort
d. Ausklappen des ersten Plattenelements (2) und Auflegen auf die vorgesehene Installationsposition;
e. Ausklappen des folgenden Plattenelements (2) und Ablegen des Plattenelements (2) auf die vorgesehene Installationsposition;
f. Wiederholen von Schritt e. bis alle Plattenelemente (2) des Wärmetauschers (1) in den vorgesehenen Installationspositionen angeordnet sind
g. Einstellen der Justierelemente (9);
h. Wiedereinbau des Solarzellenmoduls (6);
i. Anschluss der Vorlauf- (4a) und Rücklaufsammelrohre (4b) an einen Wärmeträgerkreislauf.

14. Verfahren nach Anspruch 13 **dadurch gekennzeichnet, dass** auf allen Plattenelementen (2) vor Schritt c., oder am Einbauort auf dem jeweils entfalteten Plattenelement (2) nach einem der Schritte d., e., f. oder g. Wärmeleitfolie oder Wärmeleitpaste auf der dem Solarzellenmodul (6) zugewandten Seite der Plattenelemente (2) aufgebracht wird.
